# EUROPÄISCHE PATENTSCHRIFT

(11) **EP 2 510 762 B1**
(45) Veröffentlichungstag und Bekanntmachung des Hinweises auf die Patenterteilung: **26.02.2014**
(21) Anmeldenummer: 10790405.4
(22) Anmeldetag: 07.12.2010
(51) Int. Cl.: H05K 3/28, H05K 3/30, H05K 5/06

(54) **SCHALTUNGSMODUL UND VERFAHREN ZUR HERSTELLUNG EINES SOLCHEN SCHALTUNGSMODULS**
CIRCUIT MODULE AND METHOD FOR ITS MANUFACTURE
MODULE DE CIRCUIT ET PROCÉDÉ DE SA FABRICATION

(30) Priorität: 08.12.2009 DE 102009047681
(43) Veröffentlichungstag der Anmeldung: 17.10.2012
(73) Patentinhaber: Robert Bosch GmbH, 70442 Stuttgart (DE)
(72) Erfinder: MAZINGUE-DESAILLY, Stephan, 71640 Ludwigsburg (DE); MUELLER, Michael, 71277 Rutesheim (DE)
(86) Internationale Anmeldenummer: PCT/EP2010/069072
(87) Internationale Veröffentlichungsnummer: WO 2011/070015

(56) Entgegenhaltungen:
- CN-Y- 201 233 037
- DE-A1- 19 626 083
- US-A1- 2007 071 886

## Beschreibung

### Stand der Technik

Die Erfindung geht aus von einem Schaltungsmodul nach der Gattung des unabhängigen Patentanspruchs 1 und von einem Verfahren zur Herstellung eines solchen Schaltungsmoduls nach der Gattung des unabhängigen Patentanspruchs 8.

Steuergeräte sind zur Steuerung verschiedenster Funktionen und Einrichtungen allgemein bekannt und werden im Automobilbereich in zunehmendem Maße zur Steuerung verschiedenster Funktionen eines Kraftfahrzeuges eingesetzt. Die rasant steigende Zahl elektrischer und elektronischer Anwendungen in modernen Kraftfahrzeugen führt zu einer deutlich steigenden Zahl von Steuergeräten. Dies erfordert zunehmend den Einsatz kleinerer und leichterer sowie kostengünstigerer Steuergeräte. Derartige Steuergeräte könnten somit zukünftig auch in Fahrzeugen der Mittelklasse oder in Kleinwagen oder bei motorisierten Zweirädern zum Einsatz kommen.

Steuergeräte weisen bislang ein Schaltungsmodul auf, das aus einem Schaltungsträger, beispielsweise einer Leiterplatte oder einem Keramiksubstrat, elektrischen/elektronischen Bauteilen und einem Gehäuse besteht. Durch die immer weiter steigenden Anforderungen hinsichtlich Robustheit, wie beispielsweise Korrosionsbeständigkeit und Temperaturbeständigkeit, sind neue Ausführungsformen der Schaltungsmodule erforderlich. So ist das Gehäuse des Schaltungsmoduls zunehmend als Schutzmasse ausgeführt, die den Schaltungsträger und die Bauteile umgeben. Bei der Herstellung der Schutzmasse werden der Schaltungsträger und die Bauteile in der Regel mit einem harten Vergussmaterial vergossen oder einem duroplastischen Kunststoff beispielsweise durch Thermotransfer-Molding umspritzt.

In der Offenlegungsschrift DE 102 52 755 A1 wird beispielsweise ein Schaltungsmodul beschrieben, das einen Schaltungsträger, einen auf dem Schaltungsträger montierten Schaltkreis und ein diskretes Bauelement umfasst, wobei der Schaltkreis von einer Schutzmasse umgeben ist. Um das diskrete Bauelement vor der Beanspruchung bei der Herstellung der Schutzmasse zu schützen, weist dieses einen Schutzmantel auf, der das diskrete Bauelement umgibt. Die Schutzmasse überdeckt sowohl den Schaltkreis als auch das von dem Schutzmantel umgebene diskrete Bauelement.

Bei dieser Ausführung ist es jedoch nicht möglich bestimmte Bauelemente, wie beispielsweise Elektrolytkondensatoren oder Drucksensoren, auf dem Schaltungsträger zu verwenden, da diese Bauelemente nicht komplett in die Schutzmasse eingebettet werden können. Beispielsweise halten Elektrolytkondensatoren den Druck, der beim Vergießen bzw. Umspritzen entsteht, mechanisch nicht aus. Es ist auch nicht möglich, Elektrolytkondensatoren komplett zu vergießen, da ein Elektrolytkondensator während des Betriebs "atmet", d.h. der Durchmesser des Elektrolytkondensators verändert sich während des Betriebs geringfügig. Drucksensoren nehmen beispielsweise den Umgebungsluftdruck auf, der üblicherweise in Steuergeräten von Fahrzeugmotoren zur Anpassung der Einspritzparameter auf den jeweiligen Umgebungsluftdruck benötigt wird.

Im Dokument US 2007/0071886 wird ein Schaltungsmodul mit einem Schaltungsträger, mindestens einem auf dem Schaltungsträger montierten Schaltkreis, der von einer Schutzmasse umgeben ist, und mindestens einem elektrischen/elektronischen Bauelement offenbart, das von einem Schutzmantel umgeben ist, der zumindest das mindestens eine elektrische/elektronische Bauelement vor der Schutzmasse schützt. Hierbei ist der das mindestens eine elektrische/elektronische Bauelement schützende Schutzmantel nur teilweise von der Schutzmasse umgeben.

### Offenbarung der Erfindung

Das erfindungsgemäße Schaltungsmodul mit den Merkmalen des unabhängigen Patentanspruchs 1 hat demgegenüber den Vorteil, dass ein mindestens ein elektrisches/elektronisches Bauelement schützender Schutzmantel nur teilweise von der Schutzmasse umgeben ist.

Erfindungsgemäß weist der Schutzmantel eine Druckausgleichseinrichtung auf, so dass der Umgebungsluftdruck in vorteilhafter Weise auch im Innenraum des Schutzmantels herrschen kann. Dadurch wird in vorteilhafter Weise ermöglicht, dass ein Drucksensor als elektrisches/elektronisches Bauteil vorgesehen werden kann, der den Umgebungsluftdruck zur Durchführung seiner vorgesehenen Funktion aufnimmt. Solche Drucksensoren werden üblicherweise in Steuergeräten von Fahrzeugmotoren zur Anpassung der Einspritzparameter auf den jeweiligen Umgebungsluftdruck verwendet.

Das erfindungsgemäße Verfahren zur Herstellung eines Schaltungsmoduls mit den Merkmalen des unabhängigen Patentanspruchs 8 hat demgegenüber den Vorteil, dass mindestens ein Schaltkreis und mindestens ein elektrisches/elektronisches Bauelement auf einem Schaltträger montiert wird, ein um das mindestens eine elektrische/elektronische Bauelement angeordneter Schutzmantel mit einer Druckausgleichseinrichtung auf den Schaltungsträger aufgebracht wird, der Schutzmantel mit der Druckausgleichseinrichtung auf den Schaltungsträger über ein geeignetes Werkzeug aufgepresst wird, und eine Schutzmasse vergossen wird, welche den mindestens einen Schaltkreis vollständig und den Schutzmantel mit der Druckausgleichseinrichtung des mindestens einen elektrischen/elektronischen Bauelements teilweise umgibt.

Ausführungsformen der vorliegenden Erfindung ermöglichen einen thermischen und mechanischen Schutz von elektrischen/elektronischen Bauelementen, welche aufgrund ihrer mechanischen Eigenschaften oder ihren ausführbaren Funktionen nicht direkt umspritzt oder vergossen werden können und trotzdem für umspritzte bzw. vergossene Schaltungsmodule verwendet werden. Durch das teilweise Umgeben des Schutzmantels mit Schutzmasse wird ein Bauelementeschutz realisiert, der die empfindlichen elektrischen/elektronischen Bauelemente vor dem Umspritzen bzw. Vergießen bzw. vor der Vergussmasse schützt, so dass die elektrischen/elektronischen Bauelemente ihre Funktion vollständig erfüllen können. Bei diesen Ausführungsformen ist es möglich bestimmte Bauelemente, wie beispielsweise Elektrolytkondensatoren oder Drucksensoren, auf dem Schaltungsträger zu verwenden, da diese Bauelemente nicht in die Schutzmasse eingebettet sondern von einem Schutzmantel umgeben werden. Beispielsweise halten Elektrolytkondensatoren den Druck, der beim Vergießen bzw. Umspritzen entsteht, mechanisch nicht aus. Indem der Schutzmantel zum Schutz des Elektrolytkondensators vor der Schutzmasse vorgesehen ist und dieser nur teilweise von Schutzmasse umgeben wird, ist es auch möglich, Elektrolytkondensatoren einzusetzen. Da ein Elektrolytkondensatorwährend des Betriebs "atmet", d.h. seinen Durchmesser während des Betriebs geringfügig verändert, ermöglicht der erfindungsgemäße Schutzmantel auch nach dem Vergießen der Schutzmasse ein Erfüllen der Funktion des Elektrolytkondensators. Drucksensoren nehmen beispielsweise den Umgebungsluftdruck auf, der üblicherweise in Steuergeräten von Fahrzeugmotoren zur Anpassung der Einspritzparameter auf den jeweiligen Umgebungsluftdruck benötigt wird. Indem der den Drucksensor aufnehmende Schutzmantel nur teilweise von Schutzmasse umgeben ist, kann der Drucksensor auch nach dem Vergießen der Schutzmasse den Umgebungsluftdruck aufnehmen.

Durch die in den abhängigen Ansprüchen aufgeführten Maßnahmen und Weiterbildungen sind vorteilhafte Verbesserungen des im unabhängigen Patentanspruch 1 angegebenen Schaltungsmoduls sowie des im unabhängigen Patentanspruch 8 angegebenen Verfahrens zur Herstellung eines Schaltungsmoduls möglich.

Besonders vorteilhaft ist, dass der Schutzmantel einen Aufnahmebereich zur Aufnahme des mindestens einen Bauelements und einen Flanschbereich zur Anbindung des Schutzmantels an den Schaltungsträger ausbildet. In Ausgestaltung des Schutzmantels ist der Aufnahmebereich des Schutzmantels in Form eines Topfes ausgeführt, an dessen offenem Ende der als umlaufender Kragen ausgeführte Flanschbereich angeordnet ist. Zweckmäßigerweise ist durch die einfache geometrische Struktur der zu fügenden Bauteile in vorteilhafter Weise eine einfache und kostengünstige Montage des Schutzmantels an den Schaltungsträger möglich. Der topfförmig bzw. becherförmig ausgebildete Schutzmantel weist mit dem als umlaufenden Kragen ausgeführten Flanschbereich in vorteilhafter Weise eine große Stabilität auf. Dadurch verfügt der Schutzmantel bei der Montage, insbesondere während des Aufpressvorgangs, bei welchem eine Presskraft auf den Schutzmantel aufgebracht wird, über eine hohe Formstabilität und bietet beim Umspritzen oder Vergießen mit Schutzmasse eine große Fläche als sicheren Hintergriff zur Anbindung an den Schaltungsträger. Weiterhin erfolgt über den als umlaufenden Kragen ausgeführten Flanschbereich in vorteilhafter Weise eine Verteilung der auf den Schutzmantel wirkenden Presskraft auf eine große Fläche. Ferner wird durch die geometrische Stabilität des Schutzmantels das mindestens eine elektrische/elektronische Bauelement während des Montageprozesses und während des anschließenden Betriebs des fertig gestellten Schaltungsmoduls optimal geschützt.

In Ausgestaltung der Erfindung weist der Flanschbereich mindestens eine Dichteinrichtung auf. In vorteilhafter Weise wird die mindestens eine an dem Schutzmantel angebrachte Dichteinrichtung beim Vergießen der Schutzmasse elastisch verformt und führt dadurch eine Dichtfunktion aus. In weiterer Ausgestaltung der Erfindung weist der Flanschbereich mindestens eine Struktur auf, in welche beim Vergießen der Schutzmasse in vorteilhafter Weise Schutzmasse eingebracht wird, so dass eine bessere Anbindung des Schutzmantels an die Schutzmasse und an den Schaltungsträger gewährleistet ist.

In weiterer Ausgestaltung des erfindungsgemäßen Schaltungsmoduls sind der Schutzmantel und/oder die Schutzmasse in einem Spritzgießverfahren hergestellt. In vorteilhafter Weise ergibt sich hierdurch eine einfache und kostengünstige Herstellung des Schaltungsmoduls. Insbesondere kann dadurch jede beliebige Form hergestellt werden, so dass beispielsweise der Schutzmantel derart ausgeführt werden kann, dass auch mehrere auf dem Schaltungsträger angeordnete elektrische/elektronische Bauelemente geschützt werden können.

In weiterer Ausgestaltung des erfindungsgemäßen Schaltungsmoduls ist der Schutzmantel aus einem Kunststoff, insbesondere aus einem thermoplastischen Kunststoff hergestellt. Hierdurch ist der Schutzmantel in vorteilhafter Weise in der Lage das mindestens eine elektrischelelektronische Bauelement vor den thermischen und mechanischen Beanspruchungen zu schützen, die beim Vergießen der Schutzmasse bzw. beim Umspritzen des Schaltungsmoduls mit Schutzmasse auftreten.

Ein Ausführungsbeispiel der Erfindung ist in den Zeichnungen dargestellt und wird in der nachfolgenden Beschreibung näher erläutert.

### Kurze Beschreibung der Zeichnungen

Fig. 1 zeigt eine schematische Schnittdarstellung eines Ausführungsbeispiels eines erfindungsgemäßen Schaltungsmoduls mit einem Schaltungsträger, auf welchem ein von einer Schutzmasse umgebener Schaltkreis sowie ein von einem Schutzmantel umgebenes Bauelement montiert sind.
Fig. 2 zeigt eine Draufsicht auf das Schaltungsmodul aus Fig. 1.
Fig. 3 zeigt eine perspektivische Darstellung des Schaltungsmoduls aus Fig. 1.
Fig. 4 zeigt eine perspektivische Schnittdarstellung eines Teilbereichs des Schaltungsmoduls aus Fig. 1 mit dem vom Schutzmantel umgebenen Bauelement.
Fig. 5 zeigt eine perspektivische Schnittdarstellung des Teilbereichs des Schaltungsmoduls aus Fig. 4 ohne Schutzmasse.
Fig. 6 zeigt eine perspektivische Darstellung einer Seitenansicht des Schutzmantels mit einer Dichtungseinrichtung und Strukturen.
Fig. 7 zeigt eine perspektivische Darstellung des Schutzmantels aus Fig. 6 von unten mit der Dichtungseinrichtung und den Strukturen.
Fig. 8 zeigt eine perspektivische Darstellung einer Seitenansicht des Schutzmantels mit einer Druckausgleichseinrichtung.
Ausführungsformen der Erfindung

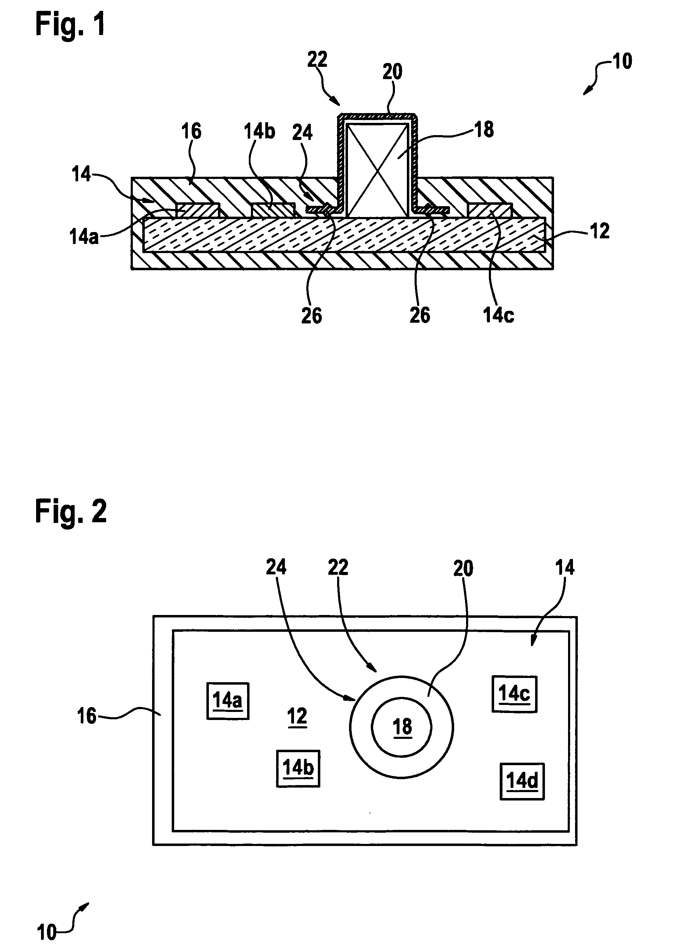

Fig. 1 und Fig. 2 zeigen eine erfindungsgemäße Ausführungsform eines Schaltungsmoduls 10 mit einem Schaltungsträger 12, einem auf dem Schaltungsträger 12 montierten Schaltkreis 14, der von einer Schutzmasse 16 umgeben ist, und einem elektrischen/elektronischen Bauelement 18, das von einem Schutzmantel 20 umgeben ist. Selbstverständlich können auch weitere Schaltkreise 14 und/oder elektrische/elektronische Bauelemente 18 auf dem Schaltungsträger 12 vorgesehen sein. Vorzugsweise umfasst der Schaltungsträger 12 eine Leiterplatte und/oder ein Substrat, das vorzugsweise als Kunststoffsubstrat oder als Keramiksubstrat ausgeführt ist.

Im vorliegenden Ausführungsbeispiel umfasst der Schaltkreis 14 mehrere elektrische/elektronische Bauelemente 14a bis 14d, welche vollständig von der Schutzmasse 16 umgeben sind. Somit bildet die Schutzmasse 16 das Gehäuse der elektronischen/elektrischen Bauelemente 14a bis 14d und schützt diese vor elektrischen und mechanischen Belastungen. Die zum Umspritzen bzw. Vergießen geeigneten elektronischen/elektrischen Bauelemente 14a bis 14d können beispielsweise als integrierte Schaltkreise (ICs), Transformatoren, Drosselspulen, Relais, Stecker oder ähnliche diskrete Bauelemente ausgeführt werden. Die diskreten Bauelemente können alle Arten von aktiven oder passiven Bauelementen, wie beispielsweise Widerstände, Kondensatoren, Induktivitäten, Halbleiterbauelemente wie Dioden, Transistoren oder ähnliches umfassen. Gleichfalls können Kombinationen solcher Bauelemente, wie beispielsweise Reihen- oder Parallelschaltungen als Schaltkreis 14 vorgesehen sein. Die Schaltkreise 14 oder diskreten Bauelemente 14a bis 14d können beispielsweise als gehäuste bzw. vergossene bzw. umspritzte Drahtbauelemente oder SMD-Bauelemente (Surface Mounted Device Bauelemente), die auf einer separaten Platine montiert sind, ausgeführt sein. Im vorliegenden Ausführungsbeispiel ist das nicht zum Umspritzen bzw. Vergießen geeignete elektrische/elektronische Bauelement 18 vorzugsweise als Elektrolytkondensator und/oder Drucksensor ausgeführt.

Das elektrische/elektronische Bauelement 18 ist von einem Schutzmantel 20 umgeben, welcher das elektrische/elektronische Bauelement 18 vor den thermischen und mechanischen Beanspruchungen schützt, die beim Vergießen der Schutzmasse bzw. beim Umspritzen des Schaltungsmoduls mit Schutzmasse auftreten. Als Material des Schutzmantels 20 ist jede Art von Material geeignet, das in der Lage ist, das elektrische/elektronische Bauelement 18 vor den thermischen und mechanischem Belastungen beim Vergießen der Schutzmasse 16 bzw. beim Umspritzen des Schaltungsmoduls 10 mit Schutzmasse 16 zu schützen. Bevorzugt ist der Schutzmantel 20 aus einem Kunststoff, insbesondere aus einem thermoplastischen Kunststoff hergestellt, der vorzugsweise elastisch verformbar ist. Vorzugsweise sind der Schutzmantel 20 und/oder die Schutzmasse 16 in einem Spritzgießverfahren hergestellt. Die Schutzmasse 16 ist vorzugsweise durch Duroplast-Molden hergestellt, wobei hohe mechanische und thermische Belastungen auftreten. Beim Duroplast-Molden werden die Bauelemente Drücken von etwa 2 bis 40 bar und Temperaturen von bis zu 180°C ausgesetzt.

Um einen Bauelementeschutz zu realisieren, welcher das empfindliche elektrische/elektronische Bauelement 18 vor dem Umspritzen bzw. Vergießen bzw. vor der Schutzmasse schützt, so dass das elektrische/elektronische Bauelement 18 seine Funktion vollständig und ungehindert erfüllen kann, ist, wie in den Fig. 1, 3 und 4 ersichtlich, erfindungsgemäß der Schutzmantel 20 des diskreten Bauelements 18 nur teilweise von der Schutzmasse 16 umgeben. Im vorliegenden Ausführungsbeispiel ist der Schaltungsträger 12 mit Ausnahme des Bereichs des Schutzmantels 20 vollständig von der Schutzmasse 16 umgeben.

Der Schutzmantel 20 kann derart ausgeführt sein, dass mehrere Bauelemente 18 aufnehmbar sind. D.h. die Form des Schutzmantels 20 kann beliebig gestaltet und ausgeführt werden, so dass auch mehrere elektrische/elektronische Bauelemente 18 geschützt werden können.

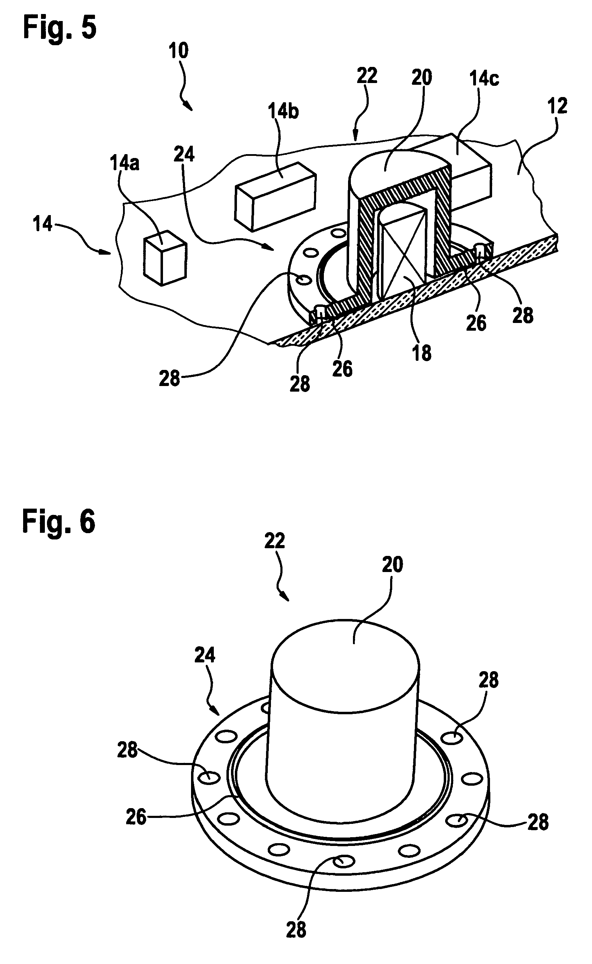

Im vorliegenden Ausführungsbeispiel bildet der Schutzmantel 20 einen Aufnahmebereich 22 zur Aufnahme des mindestens einen Bauelements 18 und einen Flanschbereich 24 zur Anbindung des Schutzmantels 20 an den Schaltungsträger 12 aus. Wie insbesondere aus Fig. 6 bis 8 ersichtlich ist, ist der Aufnahmebereich 22 des Schutzmantels 20 bevorzugt in Form eines Topfes bzw. eines Bechers ausgeführt, an dessen offenem Ende der als umlaufender Kragen ausgeführte Flanschbereich 24 angeordnet ist.

Um den Aufnahmebereich 22 des Schutzmantels 20 zur Schutzmasse 16 bzw. zum Schaltungsträger 12 hin abzudichten, weist der Flanschbereich 24 des Schutzmantels 20 mindestens eine Dichteinrichtung 26 auf. Im vorliegenden Ausführungsbeispiel ist diese Dichteinrichtung 26 gemäß Fig. 1 und 5 bis 8 als umlaufende Rippe ausgeführt.

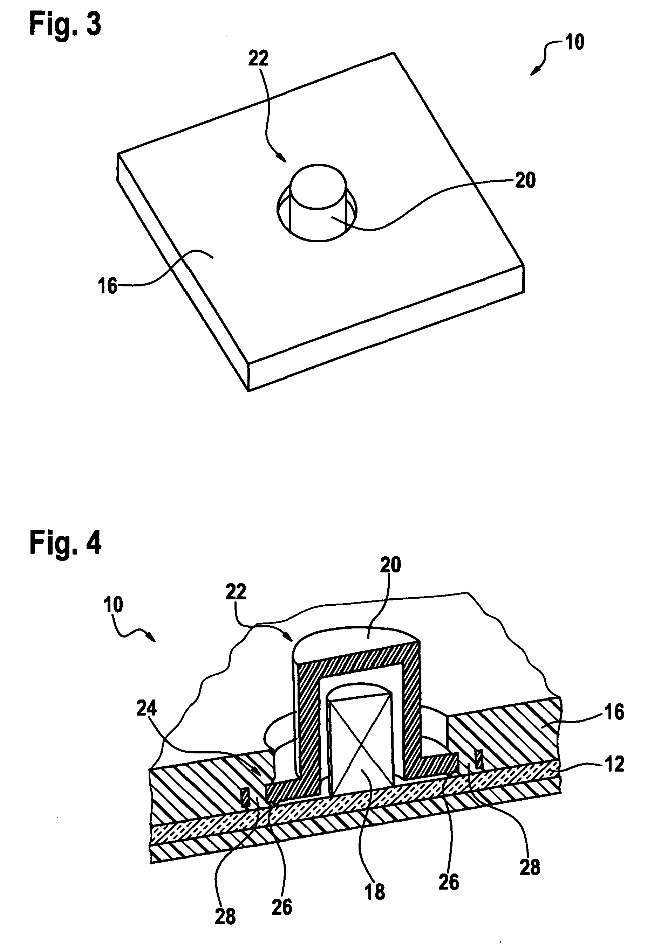

Um eine bessere Anbindung des Schutzmantels 20 an die Schutzmasse 16 und an den Schaltungsträger 12 zu gewährleisten, weist der Schutzmantel 20 im Flanschbereich 24 mindestens eine in Fig. 4 bis 8 dargestellte Struktur 28 auf. Im vorliegenden Ausführungsbeispiel sind mehrere als Durchbrüche ausgeführte Strukturen 28 vorgesehen.

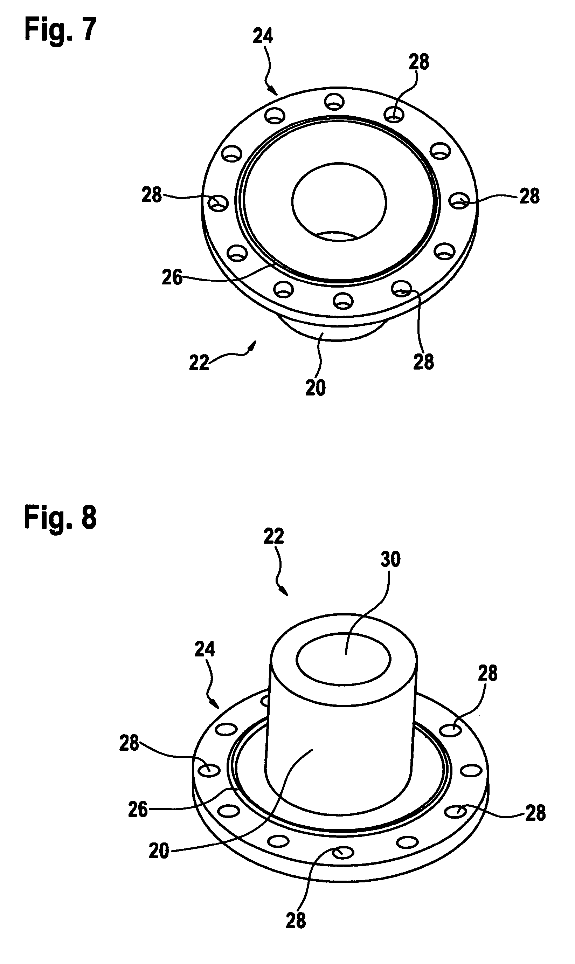

Um zu erreichen, dass der Umgebungsluftdruck auch im Aufnahmebereich 22 des Schutzmantels 20 herrscht, weist der Schutzmantel 20 gemäß Fig. 8 vorzugsweise eine Druckausgleichseinrichtung 30 auf. Im vorliegenden Ausführungsbeispiel ist diese Druckausgleichseinrichtung 30 als Membran ausgeführt, die am Boden des topfförmigen Schutzmantels 20 angeordnet ist.

Bei der Herstellung eines erfindungsgemäßen Schaltungsmoduls 10 wird ein Schaltkreis 14, der ein oder mehrere zum Umspritzen bzw. Vergießen geeignete elektrische/elektronische Bauelemente 14 bis 14d umfasst, und mindestens ein elektrisches/elektronisches Bauelement 18, das nicht zum Umspritzen bzw. Vergießen geeignet ist, auf einen Schaltungsträger 12 montiert. Ein das elektrische/elektronische Bauelement 18 umgebender Schutzmantel 20 wird auf den Schaltungsträger 12 aufgebracht bzw. aufgelegt. Der Schutzmantel 20 wird über ein geeignetes Presswerkzeug oder ein Spritz- bzw. Gießwerkzeug auf den Schaltungsträger 12 aufgepresst. Beim Umspritzen bzw. Vergießen wird der Schutzmantel 20 weiter auf den Schaltungsträger 12 aufgepresst, so dass die als Rippen ausgeführten Dichteinrichtungen 26 elastisch verformt bzw. gequetscht werden und somit eine Dichtfunktion zwischen Schutzmantel 20 und Schaltungsträger 12 ausführen. Die Schutzmasse 16 kann somit nicht in den Aufnahmebereich 22 des Schutzmantels 20 eindringen. Beim Umspritzen bzw. Vergießen der Schutzmasse 16 wird zudem in eine im Schutzmantel 20 vorgesehene Struktur 28 Schutzmasse 16 eingebracht, so dass eine bessere Anbindung des Schutzmantels 20 an die Schutzmasse 16 und an den Schaltungsträger 12 gewährleistet ist. Die Schutzmasse 16 wird so gespritzt bzw. vergossen, dass diese den Schaltkreis 14 vollständig und den Schutzmantel 20 des elektrischen/elektronischen Bauelementes 18 nur teilweise umgibt.

## Patentansprüche

1. Schaltungsmodul mit einem Schaltungsträger (12), mindestens einem auf dem Schaltungsträger (12) montierten Schaltkreis (14), der von einer Schutzmasse (16) umgeben ist, und mindestens einem elektrischen/elektronischen Bauelement (18), das von einem Schutzmantel (20) umgeben ist, der zumindest das mindestens eine elektrische/elektronische Bauelement (18) vor der Schutzmasse (16) schützt, wobei der das mindestens eine elektrische/elektronische Bauelement (18) schützende Schutzmantel (20) nur teilweise von der Schutzmasse (16) umgeben ist, **dadurch gekennzeichnet, dass** der Schutzmantel (20) eine Druckausgleichseinrichtung (30) aufweist.

2. Schaltungsmodul nach Anspruch 1, **dadurch gekennzeichnet, dass** der Schutzmantel (20) einen Aufnahmebereich (22) zur Aufnahme des mindestens einen Bauelements (18) und einen Flanschbereich (24) zur Anbindung des Schutzmantels (20) an den Schaltungsträger (12) ausbildet.

3. Schaltungsmodul nach Anspruch 1 oder 2, **dadurch gekennzeichnet, dass** der Aufnahmebereich (22) des Schutzmantels (20) in Form eines Topfes ausgeführt ist, an dessen offenem Ende der als umlaufender Kragen ausgeführte Flanschbereich (24) angeordnet ist.

4. Schaltungsmodul nach einem der Ansprüche 1 bis 3, **dadurch gekennzeichnet, dass** der Flanschbereich (24) mindestens eine Dichteinrichtung (26) und/oder mindestens eine Struktur (28) aufweist.

5. Schaltungsmodul nach einem der Ansprüche 1 bis 4, **dadurch gekennzeichnet, dass** der Schutzmantel (20) als Spritzgießteil ausgeführt ist.

6. Schaltungsmodul nach einem der Ansprüche 1 bis 5, **dadurch gekennzeichnet, dass** der Schutzmantel (20) als Kunststoffteil, insbesondere aus einem thermoplastischen Kunststoff, ausgeführt ist.

7. Verfahren zur Herstellung eines Schaltungsmoduls (10) nach einem der Ansprüche 1 bis 6, mit einem Schaltungsträger (12), mindestens einem auf dem Schaltungsträger (12) montierten Schaltkreis (14), der von einer Schutzmasse (16) umgeben ist, und mindestens einem elektrischen/elektronischen Bauelement (18), das von einem Schutzmantel (20) umgeben ist, der zumindest das Bauelement (18) vor der Schutzmasse (16) schützt, **gekennzeichnet durch**
Montieren des mindestens einen Schaltkreises (14) und des mindestens einen elektrischen/elektronischen Bauelementes (18) auf den Schaltungsträger (12),
Aufbringen des das mindestens eine elektrische/elektronische Bauelement (18) umgebenden Schutzmantels (20) mit einer Druckausgleichseinrichtung (30) auf den Schaltungsträger (12),
Aufpressen des Schutzmantels (20) mit der Druckausgleichseinrichtung (30) auf den Schaltungsträger (12) über ein Werkzeug, und
Aufbringen der Schutzmasse (16), welche den Schaltkreis (14) vollständig und den Schutzmantel (20) mit der Druckausgleichseinrichtung (30) des elektrischen/elektronischen Bauelementes (18) teilweise umgibt.

8. Verfahren nach Anspruch 7, **dadurch gekennzeichnet, dass** beim Aufbringen der Schutzmasse (16) mindestens eine an dem Schutzmantel (20) angebrachte Dichteinrichtung (26) elastisch verformt wird und eine Dichtfunktion ausführt.

9. Verfahren nach Anspruch 7 oder 8, **dadurch gekennzeichnet, dass** beim Aufbringen der Schutzmasse (16) in mindestens eine im Schutzmantel (20) vorgesehene Struktur (28) Schutzmasse (16) eingebracht wird.

10. Verfahren nach einem der Ansprüche 7 bis 9, **dadurch gekennzeichnet, dass** die Schutzmasse (16) in einem Spritzgießverfahren aufgebracht wird.

## Claims

1. Circuit module having a circuit carrier (12), at least one circuit (14) which is mounted on the circuit carrier (12) and which is surrounded by a protective mass (16), and at least one electrical/electronic component (18) which is surrounded by a protective shell (20) which protects at least the at least one electrical/electronic component (18) from the protective mass (16), the protective shell (20) protecting the at least one electrical/electronic component (18) being surrounded by the protective mass (16) only in part, **characterized in that** the protective shell (20) has a pressure equalization device (30).

2. Circuit module according to Claim 1, **characterized in that** the protective shell (20) forms a holding area (22) for holding the at least one component (18) and a flange area (24) for tethering the protective shell (20) to the circuit carrier (12).

3. Circuit module according to Claim 1 or 2, **characterized in that** the holding area (52) of the protective shell (20) is in the form of a pot, the open end of which accommodates the flange area (24), which is in the form of a circumferential collar.

4. Circuit module according to one of Claims 1 to 3, **characterized in that** the flange area (24) has at least one sealing device (26) and/or at least one structure (28).

5. Circuit module according to one of Claims 1 to 4, **characterized in that** the protective shell (20) is designed as an injection molded part.

6. Circuit module according to one of Claims 1 to 5, **characterized in that** the protective shell (20) is designed as a plastic part, particularly from a thermoplastic.

7. Method for producing a circuit module (10) according to one of Claims 1 to 6, having a circuit carrier (12), at least one circuit (14) which is mounted on the circuit carrier (12) and which is surrounded by a protective mass (16), and at least one electrical/electronic component (18) which is surrounded by a protective shell (20) which protects at least the component (18) from the protective mass (16), **characterized by**
the at least one circuit (14) and the at least one electrical/electronic component (18) being mounted on the circuit carrier (12),
the protective shell (20) which surrounds the at least one electrical/electronic component (18) and has a pressure equalization device (30) being put onto the circuit carrier (12),
the protective shell (20) with the pressure equalization device (30) being pressed onto the circuit carrier (12) using a tool, and
the protective mass (16), which surrounds the circuit (14) completely and the protective shell (20) with the pressure equalization device (30) of the electrical/electronic component (18) in part, being put on.

8. Method according to Claim 7, **characterized in that** putting on the protective mass (16) involves at least one sealing device (26) fitted to the protective shell (20) being elastically deformed and performing a sealing function.

9. Method according to Claim 7 or 8, **characterized in that** putting on the protective mass (16) involves protective mass (16) being introduced into at least one structure (28) which is provided in the protective shell (20).

10. Method according to one of Claims 7 to 9, **characterized in that** the protective mass (16) is put on using an injection molding method.

## Revendications

1. Module de circuit comprenant un porte-circuit (12), au moins un circuit (14) monté sur le porte-circuit (12), lequel est entouré par une masse de protection (16), et au moins un composant électrique/électronique (18) qui est entouré par une enveloppe de protection (20), laquelle protège au moins l'au moins un composant électrique/électronique (18) de la masse de protection (16), l'enveloppe de protection (20) qui protège l'au moins un composant électrique/électronique (18) n'étant entourée que partiellement par la masse de protection (16), **caractérisé en ce que** l'enveloppe de protection (20) présente un dispositif de compensation de la pression (30).

2. Module de circuit selon la revendication 1, **caractérisé en ce que** l'enveloppe de protection (20) forme une zone d'accueil (22) pour accueillir l'au moins un composant (18) et une zone de flasque (24) pour relier l'enveloppe de protection (20) au porte-circuit (12).

3. Module de circuit selon la revendication 1 ou 2, **caractérisé en ce que** la zone d'accueil (22) de l'enveloppe de protection (20) est réalisée sous la forme d'un pot à l'extrémité ouverte duquel est disposée la zone de flasque (24) réalisée sous la forme d'une collerette périphérique.

4. Module de circuit selon l'une des revendications 1 à 3, **caractérisé en ce que** la zone de flasque (24) présente au moins un dispositif d'étanchéité (26) et/ou au moins une structure (28).

5. Module de circuit selon l'une des revendications 1 à 4, **caractérisé en ce que** l'enveloppe de protection (20) est réalisée sous la forme d'une pièce moulée par injection.

6. Module de circuit selon l'une des revendications 1 à 5, **caractérisé en ce que** l'enveloppe de protection (20) est réalisée sous la forme d'une pièce en matière plastique, notamment en une matière thermoplastique.

7. Procédé de fabrication d'un module de circuit (10) selon l'une des revendications 1 à 6, comprenant un porte-circuit (12), au moins un circuit (14) monté sur le porte-circuit (12), lequel est entouré par une masse de protection (16), et au moins un composant électrique/électronique (18) qui est entouré par une enveloppe de protection (20), laquelle protège au moins le composant (18) de la masse de protection (16), **caractérisé par**
montage de l'au moins un circuit (14) et de l'au moins un composant électrique/électronique (18) sur le porte-circuit (12),
application de l'enveloppe de protection (20) qui entoure l'au moins un composant électrique/électronique (18), munie d'un dispositif de compensation de la pression (30), sur le porte-circuit (12),
compression de l'enveloppe de protection (20) munie du dispositif de compensation de la pression (30) sur le porte-circuit (12) par le biais d'un outil, et
application de la masse de protection (16), laquelle entoure entièrement le circuit (14) et partiellement l'enveloppe de protection (20) munie du dispositif de compensation de la pression (30) du composant électrique/électronique (18).

8. Procédé selon la revendication 7, **caractérisé en ce que** lors de l'application de la masse de protection (16), au moins un dispositif d'étanchéité (26) appliqué sur l'enveloppe de protection (20) subit une déformation élastique et réalise une fonction d'étanchéité.

9. Procédé selon la revendication 7 ou 8, **caractérisé en ce que** lors de l'application de la masse de protection (16), la masse de protection (16) est introduite dans au moins une structure (28) prévue dans l'enveloppe de protection (20).

10. Procédé selon l'une des revendications 7 à 9, **caractérisé en ce que** la masse de protection (16) est appliquée dans un procédé de moulage par injection.
